# EUROPEAN PATENT SPECIFICATION

(11) **EP 0 322 258 B1**
(45) Date of publication and mention of the grant of the patent: **05.05.1993**
(21) Application number: 88312326.7
(22) Date of filing: 23.12.1988
(51) Int. Cl.: B41M 5/24, G02F 1/13

(54) **Method for producing thin film patterns on substrates**
Verfahren für die Herstellung von dünnen Filmmustern auf Substraten
Méthode pour la production de dessins à couches minces sur des supports

(30) Priority: 23.12.1987 JP 327663/87
(43) Date of publication of application: 28.06.1989
(73) Proprietor: SEMICONDUCTOR ENERGY LABORATORY CO., LTD., Atsugi-shi Kanagawa-ken, 243 (JP)
(72) Inventor: Shinohara, Hisato, Sagamihara-shi Kanagawa-ken (JP); Sugawara, Akira, Atsugi-shi Kanagawa-ken (JP)
(74) Representative: Milhench, Howard Leslie

(56) References cited:
- DE-A- 2 812 868
- US-A- 4 314 256
- US-A- 4 568 409
- PATENT ABSTRACTS OF JAPAN, vol. 10, no. 187 (M-493)[2243], 2nd July 1986; JP A 61 031 288 (ASAHI GLASS CO. LTD) 13-02-1986
- PATENT ABSTRACTS OF JAPAN, vol. 11, no. 371 (C-462)[2318], 3rd December 1987; JP-A 62 143 847 (TOSHIBA CORP.) 27-06-1987
- PATENT ABSTRACTS OF JAPAN, vol. 10, no. 138 (M-480)[2195], 21st May 1986; JP-A-60 260 393 (HANDOUTAI ENERUGII KENKYUSHO K.K.) 23-12-1985
- PATENT ABSTRACTS OF JAPAN, vol. 9, no. 183 (M-400)[1906], 30th July 1985; JP-A-60 52 390 (DAINIPPON INSATSU K.K.) 25-03-1985
- IBM TECHNICAL DISCLOSURE BULLETIN, vol. 15, no. 2, July 1972, pages 437-438,IBM Corp., Armonk, New York, US; G.L. GLADSTONE et al.: "Liquid crystal display device configuration"
- MOLECULAR CRYSTALS AND LIQUID CRYSTALS, vol. 109, no. 1, 1984, pages 24-26, New York, US; B. BAHADUR: "Transparent and electrically conducting electrode patterns"

## Description

### BACKGROUND OF THE INVENTION

The present invention relates to the production of thin film patterns on substrates, particularly though not exclusively glass substrates.

Photolithography is a well-known technique for producing patterns in thin films formed on substrates. This technique is convenient and advantageous, having regard to the desirability of removing portions of the thin film to be processed without causing damage the underlying surface. However, a somewhat large number of steps is necessary for completing a patterning procedure in accordance with this method. Namely, after forming the thin film to be treated on a substrate, a photoresist film is formed and patterned, then the thin film is subjected to an etchant with the patterned photoresist film acting as a mask, and then the photoresist film is removed.

Laser scribing techniques are well known in the art as a low cost patterning method capable of carrying out the patterning at high speed. The YAG laser (IR light, 1.06 microns) is a representative laser which has been generally used for this purpose. Since the optical energy of this laser is only 1.23 eV, however, tin oxide, indium oxide (or ITO), Zno and so forth having optical energy gaps of about 3 to 4 eV are not effectively processed by a YAG laser, and of course transparent conductive oxide (CTO) films are generally made of this class of materials.

The laser scribing method has another shortcoming. When portions of a transparent conductive film formed over a soda-lime glass substrate, with an ion blocking film therebetween, are removed in order to produce electrode patterns thereon, the ion blocking film and the glass substrate are also partially eliminated and the surface of the glass substrate is thereby exposed. Eventually, in the case where such techniques are used in liquid crystal device manufacture, the liquid crystal material contained in the device will be contaminated by sodium ions introduced from the glass substrate. Furthermore, the scribing can cause the upper surface of the scribed film to be uneven in that residue from the scribed regions can deposit on the edges of the removal portions, the residue being piled as high as 0.5 to 1 micron. This unevenness is undesirable not only in regard to the manufacture of liquid crystal devices but also in regard to the manufacture of other kinds of electrical devices which include a laminating process in their manufacture. The uneven surface that results might possibly be the cause of electrical shorting between different layers of a laminate structure and might cause disconnection of electrical patterns superimposed thereon.

### OBJECTS AND SUMMARY OF THE INVENTION

It is thus one object of the present invention to provide a thin film pattern formed on a substrate, particularly a glass substrate, in such a way that little or no contaminant can leak from the substrate.

According to one aspect of the present invention there is provided a method of producing a conductive pattern in a thin film formed on a glass substrate, said method comprising:
forming an ion blocking film made of non-doped silicon oxide on said substrate;
forming a conductive film on said ion blocking film; and
projecting a pulsed excimer laser beam onto said conductive film so as to remove portions of said conductive film in accordance with a prescribed pattern and with the underlying portions of said ion blocking film remaining as a cover for the underlying glass substrate in order not to expose the surface of said substrate through said pattern.

In accordance with one exemplary embodiment of the invention, a glass substrate is covered with an alkali ion blocking film made of silicon oxide by sputtering, and an ITO (indium tin oxide) film is then formed on the ion blocking film. The ITO film is then treated by laser scribing in order to produce a pattern in the ITO film and, in this connection, the invention provides several key points for improving the configuration of the pattern, as explained in the following.

Firstly, heat transmission is an obstacle to the formation of clear edges of grooves. Laser scribing operates by the laser irradiated portions being heated to boiling (or sublimation), and adjacent portions can be unavoidably heated, reflow and form swollen edges adjacent to the laser scribed grooves. In order to minimize the formation of such swollen portions which can cause disconnections in an overlying film coated thereon, it is necessary to ensure that the temperature of the portions to be removed is elevated to the requisite level before substantial heating occurs in the adjacent portions of the ITO film. This is accomplished in accordance with the invention by making use of a laser beam having a short wavelength and a short pulse width. The wavelength is preferably selected to be no greater than 400 nm (3.1 eV). The pulse length is preferably no greater than 50 nanoseconds. YAG lasers, which have been widely used, cannot emit such a laser pulse of such concentrated power. The Applicants have found that excimer lasers can be used for this purpose. In this regard, the degree of damage caused to the ion blocking film during laser scribing largely depends on the thermal conductivity thereof and, since the thermal conductivity of the ion blocking film used in the practice of the invention is low, therefore the speed at which the temperature of the ion blocking film rises is correspondingly low and consequently the ion blocking film suffers little from the heating of the overlying ITO film.

Secondly, the melting points of the ion blocking film and of the ITO film are also very important. If the ion blocking film is easily melted, there is a chance that openings may be formed in the blocking film so as to expose the glass substrate surface through the grooves. In this regard, the use of ITO and non-doped Si0₂ as the conductive and ion blocking films respectively is desirable since the melting points of the former and the latter are 890°C and 1700°C respectively. The melting point of the Si0₂ film is in turn substantially higher than that of the underlying glass substrate. The energy gaps of these materials are also suitable for this purpose. The energy gaps of these materials are also suitable for this purpose, Si0₂ having an energy gap of 7 to 8 eV and therefore absorbing little or none of the energy of the short wavelength excimer laser beam, while ITO has an energy gap of 3 eV.

The method in which only the ITO film is selectively removed by the laser scribing is advantageous having regard to the desirability of obtaining patterned surfaces which are smooth and level. Even when laser scribing is performed in accordance with the teachings of the present invention, residue may remain after scribing of the ITO film. The residue, however, can be easily eliminated by HCl etch since it is composed of a porous In0ₓ and Sn0ₓ structure. In contrast, in the prior art methods utilizing YAG lasers in which the Si0₂ film is eventually partially removed, the residue is formed somewhat integrally with the remaining portions of the ITO and is composed of an indium or tin alloy which is mixed with silicon contained in the underlying ion blocking film. Such a residue cannot be eliminated by HCl etch and requires HF etch. Even if an HF etch is used, the residue cannot readily be selectively removed independently of the remaining portions of ITO film which tend to be partially removed by the HF etch.

The ion blocking film does not have to be made of Si0₂ and does not have to be formed by sputtering, but may be made from other materials so long as the above preferred conditions are satisfied. For example, the blocking film could alternatively be formed by CVD of Si0₂ or of Si₃N₄, or could be formed by sputtering of a target of heat resistant glass, such as quartz. The formation of the ion blocking film should always be carried out at a temperature below the softening temperature of the glass substrate.

Other aspects of the present invention are set forth with particularity in the appended claims and, together with the abovementioned aspects and other features of the invention and advantages thereof, will be well understood by those possessed of the appropriate skills from consideration of the following detailed description of exemplary embodiments of the invention given with reference to the accompanying drawings.

### DESCRIPTION OF THE DRAWINGS

Fig.1 is a schematic diagram showing a laser scribing apparatus for use in effecting laser patterning in accordance with the present invention;
Figs.2(A) to 2(D) are explanatory views showing the shaping of the laser beam cross-section that is effected in the apparatus of Fig.1;
Figs.3(A) to 3(B) are plan and cross-sectional views showing the fabrication of a thin-film pattern in accordance with the present invention;
Figs.4(A) to 4(D) are explanatory views illustrating steps in the manufacture of a substrate for a liquid crystal display according to the teachings of the present invention;
Figs.5(A) and 5(B) are microphotographs showing the configuration of laser scribed grooves formed in accordance with the teachings of the present invention; and
Figs.6(A) and 6(B) are schematic cross-sectional views corresponding respectively to the microphotographs of Figs.5(A) and 5(B).

### DETAILED DESCRIPTION OF THE EMBODIMENTS

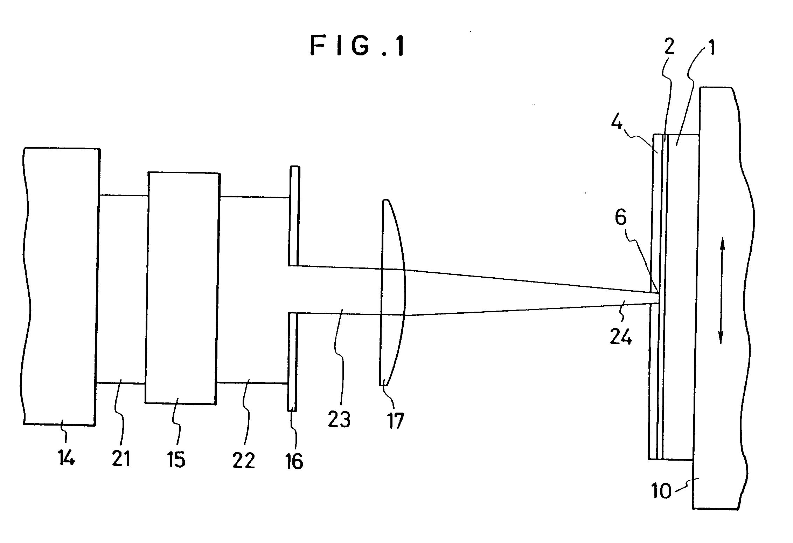

Referring now to Fig.1, shown therein is a laser scribing apparatus in accordance with the present invention. The laser apparatus is comprised of a KrF excimer laser 14 (wavelength = 248nm, Eg = 5.0 eV, efficiency = 3%, output energy = 350 mj), a beam expander 15, a mask 16, a convex cylindrical lens 17 made of synthetic quartz and a substrate holder 10. The substrate holder 10 is adapted to slide in the vertical direction as viewed in the illustration in order to change the position of a soda-lime glass substrate 1 mounted thereon. Formed on a substrate 1 are an ion blocking film 2 of 5 to 150 nm, e.g. 20 nm thickness made of silicon oxide containing very few impurity ions such as phosphorus, sodium and boron ions, and a transparent conductive film of 100 to 300 nm thickness made of ITO, tin oxide, zinc oxide or of a composite laminate thereof. The transparent conductive film 4 may be provided with a chromium or molybdenum thin film coating thereon. Depending on the case, an insulating or semiconductor film may be formed under or over the conductive film as necessary.

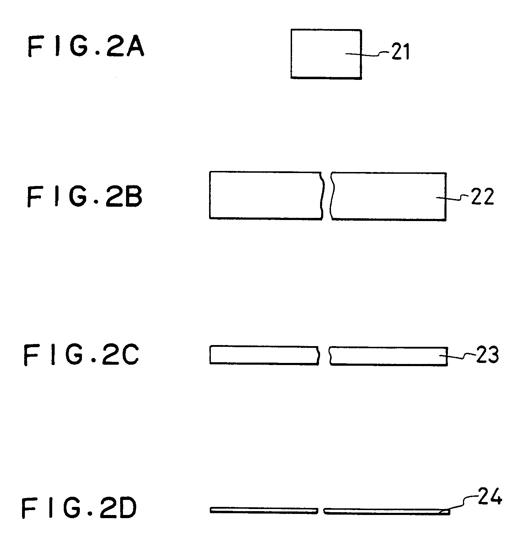

The height and width of the rectangular laser beam 21 emitted by the excimer laser 14 are 16 mm and 20 mm respectively as illustrated in Fig.2(A). The beam cross-section is expanded to have a width of 300 mm as illustrated in Fig.2(B), while its height remains unchanged, by means of the beam expander 15. The energy density of the expanded beam is 5.6 x 10⁻²mJ/mm². The expanded beam 22 is then collimated by means of the mask 16 in order to have a height of 2 mm as illustrated in Fig.2(C). The collimation of the expanded laser beam is carried out for the purpose of reducing aberration at the following cylindrical lens 17. The collimated laser beam 23 is focussed onto the surface of the substrate 1 by means of the lens 17 shown in Fig.1 and assumes the shape shown in Fig.2(D). The height of the laser beam at the surface of the substrate 1 may for example be 10 microns. In practice, the grooves to be formed on the substrate may have widths ranging from 2 microns to 200 microns, e.g. 50 microns, 20 microns, 10 microns, 5 microns and 3 microns, depending upon the applications.

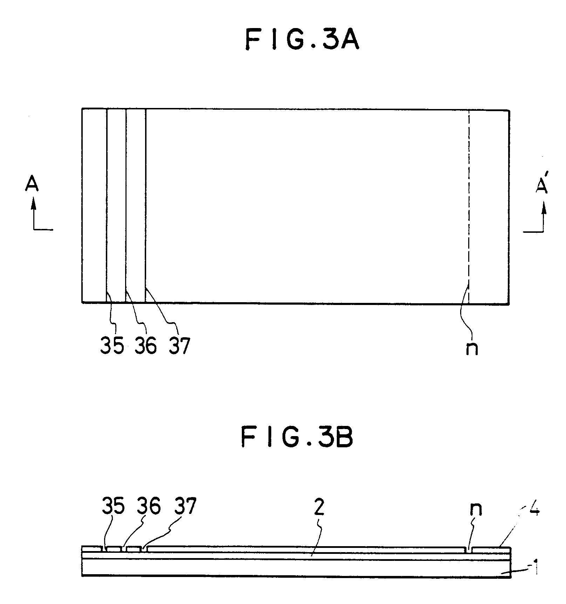

The laser beam is repeatedly projected onto the substrate 1 in the form of pulses while the substrate is moved relative to the laser beam. The pulse duration is 20 nano seconds and the frequency is from 1 to 100 Hz, for example 10 Hz. This causes grooves 35, 36, 37,... to be formed as illustrated in Fig.3(A) and 3(B). The distance between adjacent grooves may for example be 15 mm. Residue is left around and inside of the grooves, and may be selectively removed by use of an acid, for example, a hydrochloric or hydrofluoric acid (diluted by water at 1/10) or a fluoride solution mixture such as an acidic ammonia fluoride, followed by ultrasonic cleaning (29 KHz) with acetone and pure water.

If the present invention is applied to the manufacture of liquid crystal devices, liquid crystal material, of which high purity is required, is effectively prevented from being contaminated by sodium ions which otherwise would escape from the soda-lime substrate when subjected to long term use. Also, if it is used as the substrate for image sensors, solar cells and the like, amorphous semiconductor films are protected from the influence of sodium ions, which otherwise would tend to result in degradation of the photoelectric conversion ability and modification of the semiconductor to n-type.

The ion blocking film may be formed by any known techniques such as sputtering, CVD and the like. Preferably, the blocking film is first coated onto the substrate in the form of a precursor fluid, such as for example an organic silicon liquid compound such as silazanes, alcohol solutions of alcoxysilane, or any other suitable liquid compound comprising silicon oxide. A spinner may be used for depositing this coating. Alternatively, screen press printing technique, spraying technique or other coating methods may be used. The precursor film is then heated and transformed into a solid silicon oxide film. The use of such a liquid precursor makes it possible to form an ion blocking film having a smooth and level surface. The thickness of the precursor film may be 5 to 250 nm.

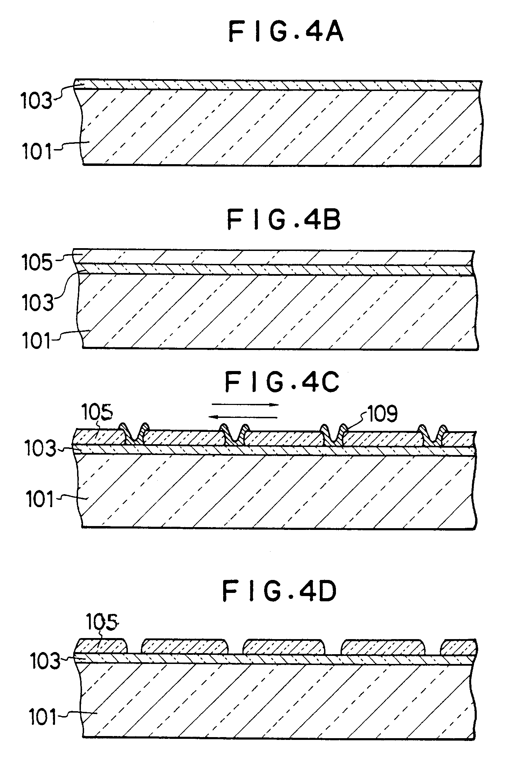

Referring now to Figs.4(A) to 4(D), a method of manufacturing a glass substrate for a liquid crystal display will now be described. An ion blocking film 103 made of non-doped silicon oxide is formed on the surface of a soda-lime glass 101. The use of a liquid precursor as explained above is desirable, not only in order to produce a smooth flat surface but also to make it unnecessary to polish the upper surface of the glass substrate. The thickness of the blocking film is 20 nm for example.

An ITO film 105 is then deposited by sputtering onto the ion blocking film 103 to a thickness of for example 0.1 to 2 microns. Then, in order to scribe the film 105 to define a pattern therein the apparatus of Fig.1 is used to project a train of laser pulses from an excimer laser onto the ITO film 105, and at the same time the substrate 101 is moved by moving the holder 10 in the lateral direction of Fig.4(B). The pulse projection and the movement of the substrate 101 are synchronously performed in order that the projections occur at intervals of 390 microns respective to the irradiated ITO film 103. The surface of the ITO film is preferably scanned three times. Accordingly, the power of the laser pulse is selected to eliminate the ITO film throughout its thickness by three times projection without causing substantial damage to the underlying blocking film 103. Although grooves can be formed by only a single projection of the laser pulse, the use of a plurality of projections is preferred in order to precisely control the effect of the laser scribing and correspondingly improve the configuration of the pattern. Finally, residue 109 deposited in the grooves and at the sides of the grooves is eliminated by a diluted HF etch to obtain the final product illustrated in Fig.4(D).

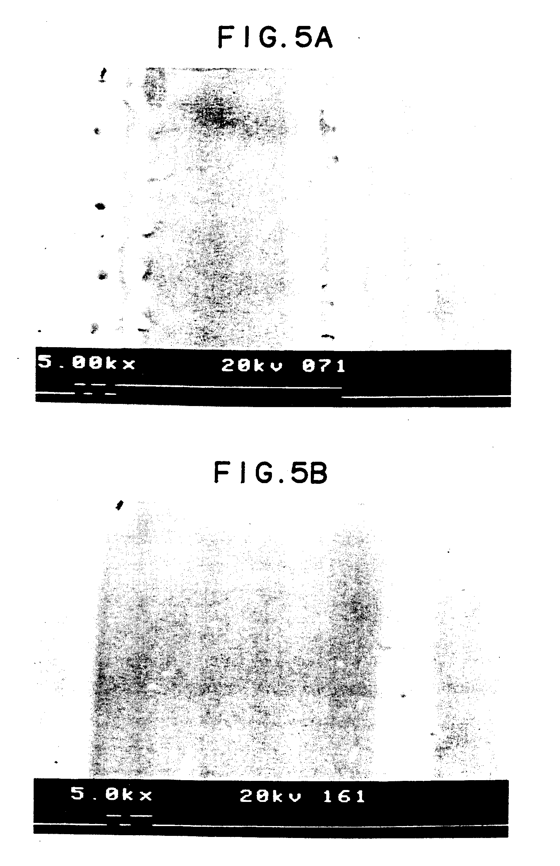

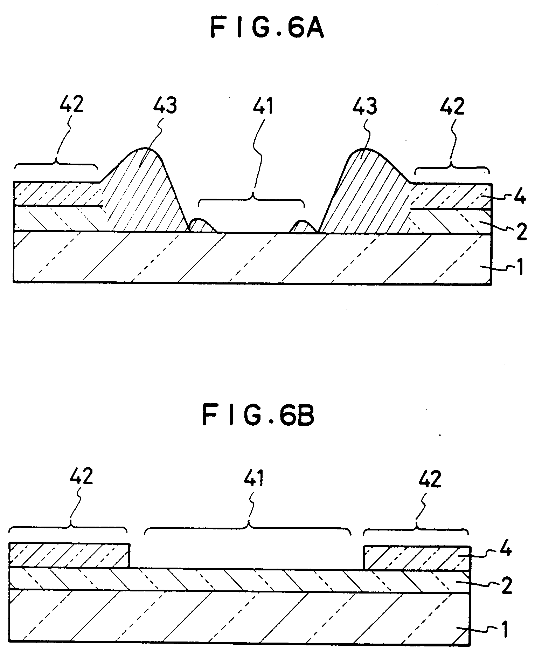

Fig.5(A) is a microscopic photograph of a groove formed in an ITO film which was formed on a glass substrate with an intervening phosphorus doped Si0₂ film. Fig.6(A) is a schematic diagram illustrating a cross-sectional view of the structure shown in Fig.5(A). Since the melting point of the silicon oxide film was lowered due to its doping with phosphorous ions, the silicon oxide film was molten during the formation of the groove and formed swollen portions by the sides of the groove. The swollen portions are formed of a mixture of silicon oxide and ITO and elimination thereof was difficult. The glass substrate was exposed through the groove.

Fig.5(B) is a microscopic photograph of a groove which was formed in an ITO film insulated from a glass substrate by an intervening silicon oxide blocking film in accordance with the present invention. The silicon oxide film was formed with few impurity ions. Fig.6(B) is a schematic diagram illustrating the cross sectional view of the structure shown in Fig.5(B). As may be seen from these figures, the boundary of the groove was very clear and little residue remained. From Figs.5(A), 5(B), 6(A) and 6(B), it may be understood that impurity doping of the ion blocking film is undesirable and the purity of the silicon oxide is important.

Current leakage was examined by applying a direct voltage of 50 V across each groove. This examination was carried out across 100 grooves of 30 cm length and 10 microns width. As a result, all the leakage currents were found to be within the range of 1 x 10⁻¹⁰ nm to 2 x 10⁻¹⁰ nm. This experiment was repeated with a phosphorous-doped SiO₂ film in place of the non-doped SiO₂ blocking film. As a result, a small current leakage was observed.

While several embodiments have been specifically described, it is to be appreciated that the present invention is not limited to the particular examples described and that modifications and variations can be made without departure from the scope of the invention as defined by the appended claims. Examples of such modifications are as follows:
Insulating films constituting a color filter may be integrally formed under or over the transparent conductive film.

Although the conductive film is preferably made of a transparent conductive material such as ITO, SiO₂ or Zno, a thin film of a metal such as chromium or molybdenum can be used in the same manner.

Although in accordance with the preferred embodiment, the grooves are narrow as compared with the remaining transparent conductive film, narrow strips of 20 microns width may be left between removed portions of 400 microns width by making use of a train of pulses which are continuously projected while the substrate is gradually moved.

## Claims

1. A method of producing a conductive pattern in a thin film formed on a glass substrate, said method comprising:
forming an ion blocking film made of non-doped silicon oxide on said substrate;
forming a conductive film on said ion blocking film; and
projecting a pulsed excimer laser beam onto said conductive film so as to remove portions of said conductive film in accordance with a prescribed pattern and with the underlying portions of said ion blocking film remaining as a cover for the underlying glass substrate in order not to expose the surface of said substrate through said pattern.

2. The method of claim 1 wherein said conductive film is made of indium tin oxide.

3. The method of claim 1 or 2 wherein said glass substrate is a soda-lime glass substrate.

4. The method of claim 1 or 2 or 3 wherein said ion blocking film is formed by coating a liquid phase compound comprising silicon oxide, and thermal annealing said liquid phase compound in order to transform the same into solid phase silicon oxide film.

5. The method of claim 4 wherein said liquid phase compound is a silazane.

6. The method of claim 4 wherein said liquid phase compound is an alcoholic solution of alcoxysilane.

7. The method of any preceding claim wherein the wavelength of said laser beam is not more than 400 nm.

8. The method of any preceding claim wherein the pulse duration of said laser beam is not greater than 50 nano seconds.

9. The method of any preceding claim further comprising the step of eliminating any residue remaining after the removal of said conductive film.

10. The method of claim 9 wherein said residue elimination step is carried out by use of an etchant such as hydrochloric acid.

11. A method of producing a conductive pattern in a thin film formed on a glass substrate, said method comprising:
forming an ion blocking film made of non-doped silicon nitride on said substrate;
forming a conductive film on said ion blocking film; and
projecting a pulsed excimer laser beam onto said conductive film so as to remove portions of said conductive film in accordance with a prescribed pattern while the underlying portion of said ion blocking film remains as a covering for the underlying glass substrate in order that the surface of said substrate is not exposed through said pattern.

## Patentansprüche

1. Verfahren zum Herstellen eines leitfähigen Musters in einem auf einem Glassubstrat ausgebildeten Dünnfilm, welches Verfahren folgendes aufweist:
- Ausbilden eines ionenblockierenden Films aus undotiertem Siliziumoxid auf dem Substrat;
- Ausbilden eines leitfähigen Films auf dem ionenblockierenden Film; und
- projizieren eines gepulsten Excimerlaserstrahls auf den leitfähigen Film, um Abschnitte dieses leitfähigen Films gemäß einem vorgegebenen Muster zu entfernen, wobei die darunterliegenden Abschnitte des ionenblockierenden Films als Abdeckung für das darunterliegende Glassubstrat verbleiben, damit die Oberfläche des Glassubstrates nicht durch das Muster freigelegt wird.

2. Verfahren nach Anspruch 1, bei dem der leitfähige Film aus Indium-Zinn-Oxid besteht.

3. Verfahren nach einem der Ansprüche 1 oder 2, bei dem das Glassubstrat ein Normalglassubstrat ist.

4. Verfahren nach einem der Ansprüche 1, 2 oder 3, bei dem der ionenblockierende Film dadurch hergestellt wird, daß eine Siliziumoxid enthaltende Verbindung in der Flüssigphase aufgetragen wird und diese Flüssigphasenverbindung thermisch behandelt wird, um sie in einen Festphasen-Siliziumoxidfilm umzuwandeln.

5. Verfahren nach Anspruch 4, bei dem die Flüssigphasenverbindung ein Silazan ist.

6. Verfahren nach Anspruch 4, bei dem die Flüssigphasenverbindung eine alkoholische Lösung von Alkoxysilan ist.

7. Verfahren nach einem der vorstehenden Ansprüche, bei dem die Wellenlänge des Laserstrahls nicht größer als 400 nm ist.

8. Verfahren nach einem der vorstehenden Ansprüche, bei dem die Pulsdauer der Laserstrahls nicht größer als 50 Nanosekunden ist.

9. Verfahren nach einem der vorstehenden Ansprüche, das ferner den Schritt des Beseitigens jeglichen Rückstandes enthält, der nach dem Entfernen des leitfähigen Films verbleibt.

10. Verfahren nach Anspruch 9, bei dem der Rückstandentfernungsschritt unter Verwendung eines Ätzmittels, wie Fluorwasserstoffsäure, ausgeführt wird.

11. Verfahren zum Herstellen eines leitfähigen Musters in einem auf einem Glassubstrat ausgebildeten Dünnfilm, welches Verfahren folgendes aufweist:
- Ausbilden eines ionenblockierenden Films aus undotiertem Siliziumnitrid auf dem Substrat;
- Ausbilden eines leitfähigen Films auf dem ionenblockierenden Film; und
- Projizieren eines gepulsten Excimerlaserstrahls auf den leitfähigen Film, um Abschnitte dieses leitfähigen Films gemäß einem vorgegebenen Muster zu entfernen, wobei die darunterliegenden Abschnitte des ionenblockierenden Films als Abdeckung für das darunterliegende Glassubstrat verbleiben, damit die Oberfläche des Glassubstrates nicht durch das Muster freigelegt wird.

## Revendications

1. Procédé de production d'un dessin conducteur dans un film mince formé sur un substrat de verre, ledit procédé consistant:
à former, sur ledit substrat, un film de blocage ionique réalisé en oxyde de silicium non dopé;
à former un film conducteur sur ledit film de blocage ionique; et
à projeter un faisceau de laser excimer pulsé sur ledit film conducteur de façon à éliminer des parties dudit film conducteur en fonction d'un dessin prédéterminé, les parties sous-jacentes dudit film de blocage ionique subsistant en tant que couverture pour le substrat de verre sous-jacent afin de ne pas exposer la surface dudit substrat par l'intermédiaire dudit dessin.

2. Procédé selon la revendication 1, dans lequel ledit film conducteur est réalisé en oxyde d'indium-étain.

3. Procédé selon la revendication 1 ou la revendication 2, dans lequel ledit substrat de verre est un substrat de verre de chaux sodée.

4. Procédé selon l'une quelconque des revendications 1, 2 et 3, dans lequel ledit film de blocage ionique est formé par application d'un composé à l'état liquide comprenant de l'oxyde de silicium, et par recuit thermique du composé à l'état liquide afin de transformer ce dernier en un film d'oxyde de silicium à l'état solide.

5. Procédé selon la revendication 4, dans lequel ledit composé à l'état liquide est un silazane.

6. Procédé selon la revendication 4, dans lequel ledit composé à l'état liquide est une solution alcoolique d'alkoxysilane.

7. Procédé selon l'une quelconque des revendications précédentes, dans lequel la longueur d'onde dudit faisceau laser ne dépasse pas 400 nm.

8. Procédé selon l'une quelconque des revendications précédentes, dans lequel la durée d'impulsion dudit faisceau laser n'est pas supérieure à 50 nanosecondes.

9. Procédé selon l'une quelconque des revendications précédentes, comprenant en outre l'étape consistant à éliminer tout résidu subsistant après le retrait dudit film conducteur.

10. Procédé selon la revendication 9, dans lequel ladite étape d'élimination de résidu est effectuée à l'aide d'un agent d'attaque tel que l'acide chlorhydrique.

11. Procédé de production d'un dessin conducteur dans un film mince formé sur un substrat de verre, ledit procédé consistant:
à former, sur ledit substrat, un film de blocage ionique réalisé en nitrure de silicium non dopé;
à former un film conducteur sur ledit film de blocage ionique; et
à projeter un faisceau de laser excimer pulsé sur ledit film conducteur de façon à éliminer des parties dudit film conducteur en fonction d'un dessin prédéterminé, les parties sous-jacentes dudit film de blocage ionique subsistant en tant que couverture pour le substrat de verre sous-jacent afin de ne pas exposer la surface dudit substrat par l'intermédiaire dudit dessin.
